(19) Europäisches Patentamt / European Patent Office / Office européen des brevets

(11) **EP 3 427 397 B1**

(12) **EUROPEAN PATENT SPECIFICATION**

(45) Date of publication and mention
of the grant of the patent:
**21.10.2020 Bulletin 2020/43**

(21) Application number: **16710714.3**

(22) Date of filing: **15.03.2016**

(51) Int Cl.:
*H04B 7/0413* (2017.01)          *H04L 25/03* (2006.01)
*H03M 13/29* (2006.01)          *H03M 13/00* (2006.01)
*H04L 27/26* (2006.01)

(86) International application number:
**PCT/EP2016/055575**

(87) International publication number:
**WO 2017/157425 (21.09.2017 Gazette 2017/38)**

(54) **POLARIZED SPECTRALLY-PRECODED TRANSMISSION**

POLARISIERTE SPEKTRAL-VORCODIERTE ÜBERTRAGUNG

TRANSMISSION POLARISÉE PRÉCODÉE SPECTRALEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.01.2019 Bulletin 2019/03**

(73) Proprietor: **Huawei Technologies Co., Ltd.
Longgang District
Shenzhen, Guangdong 518129 (CN)**

(72) Inventors:
• **PITAVAL, Renaud-Alexandre
164 40 Kista (SE)**

• **POPOVIC, Branislav
164 40 Kista (SE)**

(74) Representative: **Körber, Martin Hans
Mitscherlich PartmbB
Patent- und Rechtsanwälte
Sonnenstraße 33
80331 München (DE)**

(56) References cited:
**WO-A1-2011/009239          WO-A2-96/24989
US-A1- 2010 254 494          US-A1- 2014 362 934**

**Description**

**TECHNICAL FIELD**

The present invention relates to a first processing unit and a second processing unit. The present invention also relates to a system for transformed transmission and to methods for transformed transmission and receiving. Further, the present invention also relates to a computer-readable storage medium storing program code, the program code comprising instructions for carrying out such methods.

**BACKGROUND**

Orthogonal frequency division multiplexing (OFDM) is a chosen air interface of many communication systems, e.g., 3GPP LTE, due to its high spectral efficiency and low-implementation complexity.

Single Carrier-Frequency Division Multiple Access (SC-FDMA) is a channel access method where a transmission is DFT-spread over OFDM subcarriers. A recognised advantage of SC-FDMA over OFDMA is its low peak-to-average-power-ratio (PAPR). As such, SC-FDMA has been chosen as the air-interface for LTE uplink transmission. In LTE, consecutive subcarriers are mapped after DFT-spreading. This is referred to as *localized subcarrier mapping*. An alternative not used in LTE is called distributed subcarrier mapping.

A main disadvantage of OFDM and SC-FDMA modulation is their high out-of-band (OOB) emission. OOB emission causes interference to adjacent frequency bands. If one is able to reduce the OOB, adjacent frequency bands can be more densely packed, thus, improving system spectral efficiency.

Spectral precoding is a method that can provide drastically low OOB by precoding the data symbols before feeding the modulator. This is achieved by confining the transmission in a specific subspace guaranteeing a low level of OOB emission.

Spectral precoding, e.g. using a projection precoding method, can project the data symbol vector in order to confine the transmission to the desired data subspace. One advantage of projection precoding is that it has been shown in prior-art to be compatible with MIMO technologies, as it provides the minimum distorted version of the original signal in the desired subspace.

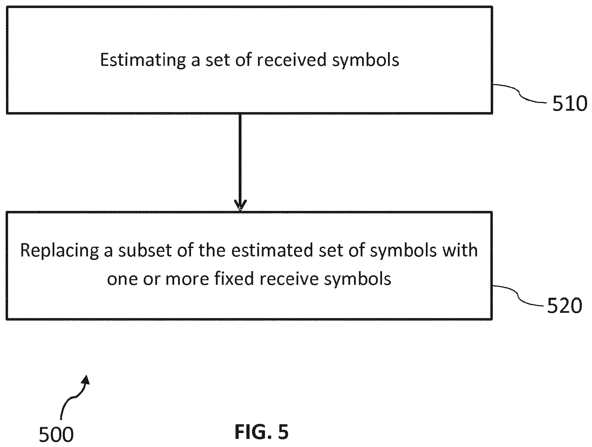

US 2014/362934 A1 discloses transform units for generating transformed symbol vectors. It further discloses (see e.g. [0013]) generating dummy symbols and the insertion of dummy sequences which are embedded into the modulation symbol vector. Further, it is disclosed (see e.g. [0015]) that the transform index n of each of the orthonormal transform is encoded into a number $N_i$ of indexing symbols $s_i^n$ selected from signal constellation of the baseband modulator, and the indexing symbols are embedded as selected elements of the modulation symbol vector that is transformed by the orthonormal transform with index n. Further, it is disclosed (see e.g. fig. 5) that the receiver comprises a transform index detection block, a bank of inverse transforms block and a dummy/indexing symbols detection block.

WO 96/24989 A2 discloses that each communication onset will be required to post a fixed symbol preamble prior to data transmission in order to mitigate the problem of independent phase shifts due to separate sending units.

US 2010/254494 A1 discloses inserting known data and replacing the pre-decided RS parity value.

WO 2011/009239 A1 discloses orthogonal projection, the data symbol vector d being projected on the nullspace of constraint matrix A yielding the precoded vector d.

A projection precoder has the drawback of creating inter-symbol interference at the transmitter that cannot be totally mitigated at the receiver, corresponding to a small loss in capacity. As a result, interference cannot always be eliminated at the receiver, but for OFDM system with low MCS, most of the interference has been shown to be mitigated by iterative symbol detection.

**SUMMARY OF THE INVENTION**

The objective of the present invention is to provide a first processing unit, a second processing unit, a system and methods which overcome one or more of the above-mentioned problems of the prior art. The present invention is defined by a processing unit for a transmitter according to independent claim 1, a system for transformed transmission according to independent claim 6 and a method for transformed transmission according to independent claim 11.

Additional features of the invention are provided in the dependent claims. In the following, parts of the description and drawings referring to embodiments which are not covered by the claims are not presented as embodiments of the invention, but as examples useful for understanding the invention.

A first aspect of the invention provides a first processing unit for a transmitter, the processing unit comprising:

-   a transformation unit configured to replace a subset of a set of input symbols with one or more fixed symbols to obtain a transformed set of symbols, and

- a precoder configured to apply a precoding matrix to the transformed set of symbols to obtain a precoded transformed set of symbols,

wherein the subset is based on a distortion of the precoding matrix.

The processing unit of the first aspect can be used e.g. in a transmitter that is configured to transmit a plurality of data symbols. The data symbols can be provided to the transformation unit as set of input symbols. In the following, the transformation performed by the transformation unit is also referred to as "polarization".

The processing unit can be implemented on a processor. This processor can be configured to obtain the set of input symbols.

The choice of the subset is based on a distortion of the precoding matrix. In particular, the choice of the subset can be based on a matrix-created distortion which is created by the precoding matrix, e.g. in the sense that it is based on an output-vector distortion of an output vector of the precoder (using the precoding matrix) compared to an input vector of the precoder. A measure of the distortion created by the precoding matrix may be based on values of the precoding matrix, in particular based only on diagonal values of the precoding matrix.

In a preferred embodiment, the processing unit can be configured to compute the subset, e.g. indices of the subset, based on a distortion of the precoding matrix. To this end, the first processing unit can be configured to compute and/or measure a distortion of the precoding matrix. This has the advantage that the processing unit can adapt to different choices of the precoding matrix.

In other embodiments, the subset is not chosen by the processing unit of the first aspect, but rather is predefined, based on a distortion of the precoding matrix, wherein the precoding matrix can also be predefined. This has the advantage that the processing unit does not need to compute the subset, e.g. computing indices that identify the subset.

The set of input symbols can correspond to a set of input streams of the precoder. Thus, the subset of the set of input symbols can correspond to fixed input streams of the precoder.

A size of the set of input symbols can correspond to a number of rows of the precoding matrix. The processing unit of the first aspect can be configured to iteratively replace a subset of subsequent sets of input symbols with the one or more fixed symbols. For example, a transmitter can comprise a serial-to-parallel converter, the set of input symbols can be provided to the processing unit in a parallelized manner and the subset corresponds to a subset of the parallelized streams. This can be performed iteratively.

Preferably, the size of the set of input symbols can correspond to a number of sub-carriers that are used by the transmitter. In particular, this can be the case when OFDM or SC-FDMA with localized subcarrier mapping is used. For example, if K sub-carriers are used, the precoding matrix can be a $K \times K$ matrix and the set of symbols can comprise $K$ symbols. A serial-to-parallel converter can be configured to always convert $K$ symbols from an input stream to a parallelized set of $K$ input symbols.

In other embodiments of the invention, the set of input symbols are provided to the processing unit in a sequential manner and the subset corresponds to periodical inputs of the precoder. In other words, replacing the subset of the set of input symbols with fixed symbols can be performed when the input symbols are available in serial or in parallelized form.

The one or more fixed symbols may be identical (e.g. all zero symbols) or they may be different symbols, e.g. selected according to a predetermined pattern.

Preferably, the one or more fixed symbols are symbols from the constellation of the used modulation scheme. This has the advantage that the transmit power is upheld during transmission of the fixed ("dummy") symbols.

The processing unit of the first aspect can be used to implement a method for improving the spectral efficiency of spectrally precoded systems, in particular spectrally precoded systems employing a projection precoder.

The processing unit of the first aspect can be used to implement a transmission method based on polarization of input coded data symbols in spectrally precoded transmission. Here, polarization refers to separating symbols into two groups, a first group that comprises (unmodified) input symbols and a second group that comprises e.g. fixed symbols.

Thus, the input data symbols can be polarized based on a distortion of the precoding matrix. In particular, they can be polarized according to an interference level introduced among the symbols by the spectral projection precoder. One group of polarized data symbols carries information to the receiver. The other group is treated as fixed "dummy" symbols providing only supplementary information to the receiver to demodulate and decode the first group of symbols.

The benefit is to minimize the loss of spectral efficiency inherent to spectral precoding.

In a first implementation of the processing unit according to the first aspect, the precoding matrix is an orthogonal projection matrix, and one or more indices of the subset of the set of input symbols correspond to one or more indices of smallest diagonal values of the precoding matrix.

Having an orthogonal projection matrix has the advantage that the distortion created by the projection matrix can be determined in a particularly simple way based on diagonal values of the precoding matrix. In a second implementation of the processing unit according to the first aspect, the subset of the set of input symbols comprises $N_t$ elements with $M/2 \leq N_t \leq 3M$, wherein $M$ is a rank of a null space of the precoding matrix.

For example, the subset can be chosen such that it corresponds to the $N_t$ elements which correspond to the

lowest $N_t$ diagonal values of the precoding matrix.

Experiments have shown that this provides a good trade-off between reducing the OOB (through the targeted transmission of dummy symbols) and losing effective transmission rate (because dummy symbols instead of data symbols are transmitted).

In a third implementation of the processing unit according to the first aspect, the processing unit further comprises an interleaver configured to map from a predefined puncturing bit pattern to a set of indices of the subset of the set of input symbols.

In particular, the processing unit of the third implementation of the first aspect can be configured to map punctured bits (as defined by the puncturing bit pattern) to the subset of the set of input symbols. This has the advantage that punctured bits (that do not carry information) are mapped to the subset of the set of input symbols that are replaced with fixed symbols and thus are anyhow not suitable to carry information.

The mapping can be a one-to-one mapping and/or a permutation.

In a fourth implementation of the processing unit according to the first aspect, the processing unit further comprises an OFDM modulator or a SC-FDMA modulator configured to modulate the transformed set of symbols.

Experiments have shown that the transformed transmission of the processing unit is particularly suitable for transmission using OFDM and/or SC-FDMA modulation.

A second aspect of the invention refers to a processing unit for a receiver, the processing unit comprising:

- an estimator configured to estimate a set of received symbols based on a precoding matrix to obtain an estimated set of symbols, and
- a transformation unit configured to replace a subset of the estimated set of symbols with one or more fixed receive symbols to obtain a transformed estimated set of symbols.

The processing unit of the second aspect can be used e.g. to receive symbols that were transmitted using a transmitter that comprises a processing unit according to the first aspect. To this end, the estimator of the processing unit of the second aspect can have knowledge of the precoding matrix that is used by the first processing unit of the transmitter, i.e., the precoding matrix of the estimator of the processing unit of the second aspect can correspond to the precoding matrix of the transformation unit of the processing unit of the first aspect.

Preferably, the value of the fixed symbols is chosen as an average of the transmit constellation, e.g. zero for QAM. As such these symbols reflect complete uncertainty and do not impact a decoding decision.

As will be described in more detail further below, the processing unit of the second aspect can be configured to be used in a system of a transmitter comprising a processing unit according to the first aspect and a receiver comprising the processing unit according to the second aspect.

In a first implementation of the processing unit of the second aspect, the processing unit of the second aspect further comprises a de-interleaver configured to map from a set of indices of the subset of the set of input symbols to a predefined puncturing bit pattern.

In particular, the processing unit of the second aspect can be configured to map to from the subset of the set of input symbols to punctured bits or symbols of the puncturing bit pattern. The processing unit of the first implementation of the second aspect can have the advantage that the one or more fixed receive symbols (which do not carry information) are mapped to bits or symbols of the puncturing bit pattern that do not carry information.

A third aspect of the invention refers to a system for transformed transmission, the system comprising:

- a transmitter comprising a transmitter processing unit, which is a processing unit according to the first aspect of the invention, and
- a receiver comprising a receiver processing unit, which is a processing unit according to the second aspect of the invention,

wherein the subset of the set of input symbols of the transmitter processing unit is a subset of the subset of the estimated set of symbols of the receiver processing unit.

Having a system of a transmitter and a receiver wherein the transmitter comprises a transmitter processing unit and the receiver comprises a receiver processing unit which are coordinated in the sense that the set of input symbols of the transmitter processing unit is a subset of the subset of the estimated set of symbols of the receiver processing unit has the advantage that OOB emissions can be reduced with only a small loss in effective transmission rate.

In a first implementation of the system of the third aspect, the subset of the set of input symbols of the transmitter processing unit and the subset of the estimated set of symbols of the receiver processing unit have the same elements.

Thus, the processing unit of the receiver can replace those symbols with fixed symbols that were previously replaced with fixed symbol in the transmitter (by the processing unit of the transmitter).

In a second implementation of the system of the third aspect, the estimator of the receiver processing unit is configured to estimate the set of received symbols based on the precoding matrix of the transmitter processing unit and based on the subset of the set of input symbols of the transmitter processing unit.

In other words, the estimator of the receiver processing unit can have knowledge of what symbols were replaced with fixed symbols by the processing unit of the transmitter and use this knowledge to estimate the set of received symbols. In particular, the estimator can also have knowledge of what the fixed symbols used by the processing unit of the transmitter were, and also use this knowledge to estimate the received set of symbols.

In a third implementation of the system of the third aspect, the interleaver of the transmitter processing unit is configured to perform a mapping that is inverse to the mapping of the de-interleaver of the receiver processing unit.

This has the advantage that the receiver processing unit can undo the mapping that war performed by the transmitter processing unit.

A fourth aspect of the invention refers to a method for transformed transmission, the method comprising:

- replacing a subset of a set of input symbols with one or more fixed transmit symbols to obtain a transformed set of symbols, and
- applying a precoding matrix to the transformed set of symbols to obtain a precoded transformed set of symbols.

The methods according to the fourth aspect of the invention can be performed by the processing unit according to the first aspect of the invention. Further features or implementations of the method according to the fourth aspect of the invention can perform the functionality of the processing unit according to the first aspect of the invention and its different implementation forms.

In a first implementation of the method of the fourth aspect, the method for transformed transmission further comprises a step of transmitting to a receiver processing unit an information about the precoding matrix, the subset of the set of input symbols and/or a subset of the estimated set of symbols.

The method according to the first implementation of the fourth aspect has the advantage that it can be run on a transmitter that can communicate with different receivers, in particular with different receiver that are configured to use different precoding matrices.

A fifth aspect of the invention refers to a method for transformed receiving, the method comprising:

- estimating a set of received symbols based on a precoding matrix to obtain an estimated set of symbols, and
- replacing a subset of the estimated set of symbols with one or more fixed receive symbols to obtain a transformed estimated set of symbols.

The methods according to the fifth aspect of the invention can be performed by the processing unit according to the second aspect of the invention. Further features or implementations of the method according to the fifth aspect of the invention can perform the functionality of the processing unit according to the second aspect of the invention and its different implementation forms.

A sixth aspect of the invention refers to a computer-readable storage medium storing program code, the program code comprising instructions for carrying out the method of the fourth of fifth aspect or one of the implementations of the fourth or fifth aspect.

## BRIEF DESCRIPTION OF THE DRAWINGS

To illustrate the technical features of embodiments of the present invention more clearly, the accompanying drawings provided for describing the embodiments are introduced briefly in the following. The accompanying drawings in the following description are merely some embodiments of the present invention, but modifications on these embodiments are possible without departing from the scope of the present invention as defined in the claims.

FIG. 1        is a block diagram illustrating a processing unit for a transmitter in accordance with an embodiment of the invention,

FIG. 2        is a block diagram illustrating a processing unit for a receiver in accordance with a further embodiment of the invention,

FIG. 3        is a flow chart of a system for transformed transmission in accordance with an embodiment of the invention,

FIG. 4        is a flow chart of a method for transformed transmission in accordance with a further embodiment of the invention,

FIG. 5    is a flow chart of a method for transformed rreceiving in accordance with a further embodiment of the invention,

FIG. 6    is a schematic illustration a transmitter and a receiver in accordance with a further embodiment of the t invention,

FIG. 7    is a schematic illustration of a polarizer in accordance with a further embodiment of the invention,

FIGs. 8a to 8d    are diagrams showing diagonal values of projection precoders for SC-FDMA and OFDM,

FIG. 9    is a diagram showing average SER per index with and without knowledge of dummy symbols from transmit transformation,

FIG. 10    shows three diagrams that illustrate a spectral efficiency as a function of $N_r$ disregarded symbols in a receiver with and without transmit transformation,

FIG. 11    shows spectral efficiency of the method compared to prior-art,

FIG. 12    shows out-of-band emissions of the method compared to prior-art methods, and

FIG. 13    shows peak-to-average-power-ratio (PAPR) of the method compared to prior-art methods.

## DETAILED DESCRIPTION OF THE EMBODIMENTS

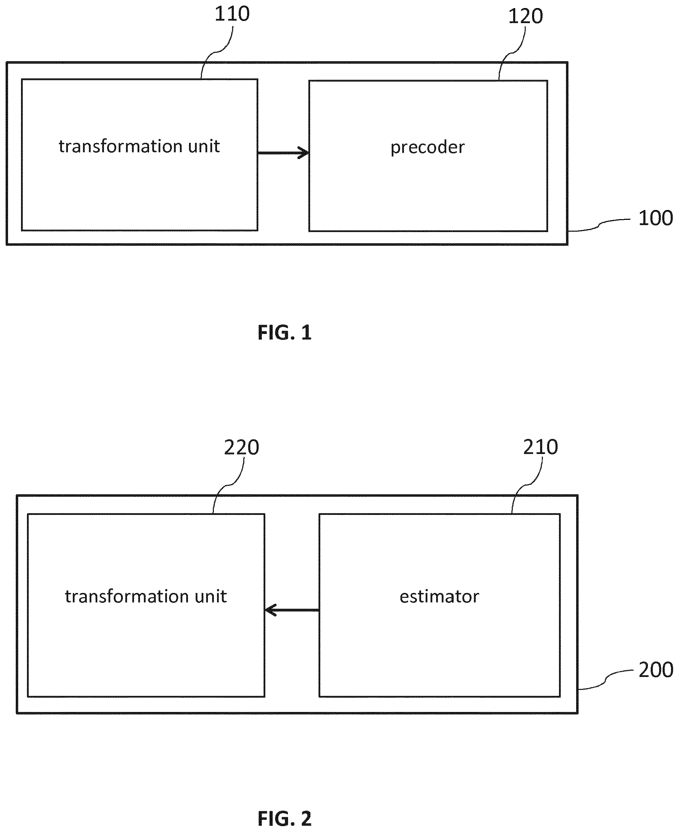

FIG. 1 shows a processing unit 100. The processing unit 100 comprises a transformation unit 110 and a precoder 120. The processing unit 100 can be part of a processing pipeline in a transmitter (not shown in FIG. 1).

The processing unit 100 is configured to replace a subset of a set of input symbols with one or more fixed symbols to obtain a transformed set of symbols. For example, the transforming unit 110 can be configured to receive the set of input symbols from a previous element in a processing pipeline of a transmitter.

The precoder 120 is configured to apply the precoding matrix to the transformed set of symbols to obtain a precoded transformed set of symbols. The precoding matrix can be chosen such that it reduces an out-of-band (OOB) emission.

The subset that is used by the transforming unit 110 is based on a distortion of the precoding matrix of the precoder 120. For example, the distortion of the precoding matrix may be directly related to values of the precoding matrix. For example, the subset can correspond to smallest values of diagonal values of the precoding matrix. In particular, the subset can correspond to the n smallest diagonal values of the precoding matrix, wherein n can be a predetermined number.

FIG. 2 shows a second processing unit 200. The second processing unit comprises an estimator 210 and a transformation unit 220. The processing unit 200 can be part of a processing pipeline in a receiver (not shown in FIG. 2).

The estimator 210 is configured to estimate a set of received symbols based on a precoding matrix to obtain an estimated set of symbols.

The transformation unit 220 is configured to replace a subset of the estimated set of symbols with one or more fixed receive symbols to obtain a transformed estimated set of symbols.

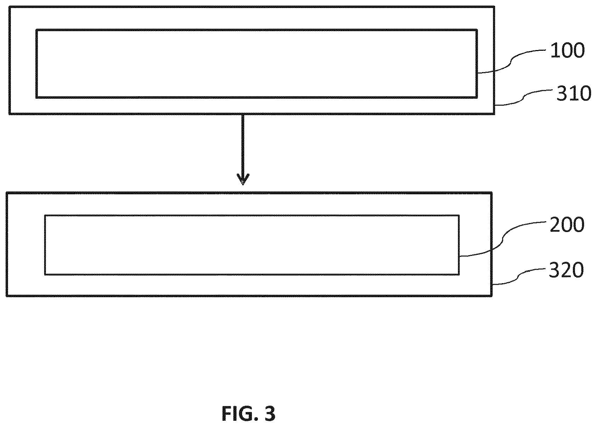

FIG. 3 shows a system 300 for transformed transmission, the system 300 comprising a transmitter 310 and a receiver 320.

The transmitter 310 comprises a transmitter processing unit 100, e.g. the processing unit 100 of FIG. 1.

The receiver 320 comprises a receiver processing unit 200, e.g. the processing unit 200 of FIG. 2.

The system 300 is configured such that the subset of the set of input symbols of the transmitter processing unit 100 is a subset of the subset of the estimated set of symbols of the receiver processing unit 200.

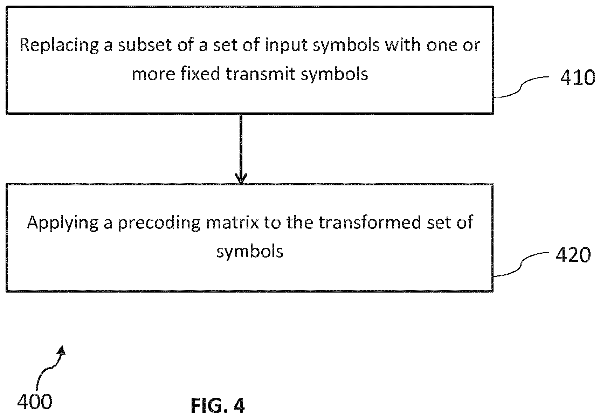

FIG. 4 shows a method 400 for transformed transmission, the method comprising a first step 410 of replacing a subset of a set of input symbols with one or more fixed transmit symbols to obtain a transformed set of symbols.

The method comprises a second step 420 of applying a precoding matrix to the transformed set of symbols to obtain a precoded transformed set of symbols.

The method may comprise a further step (not shown in FIG. 4) of transmitting information about the precoding matrix and/or the one or more fixed transmit symbols to a receiving processing unit.

FIG. 5 shows a method 500 for transformed receiving, the method comprising a first step 510 of estimating a set of received symbols based on a precoding matrix to obtain an estimated set of symbols and a second step 520 of replacing a subset of the estimated set of symbols with one or more fixed receive symbols to obtain a transformed estimated set of symbols.

A full transceiver method for a spectral precoded system with projection precoder includes a transmitter with a spectral precoder, and a receiver with a corresponding iterative receiver based on the spectral precoder.

In the following, mathematical properties shall be explained in more detail:

## Transmission and rate loss

Spectral precoding is a method where the data are multiplied by a matrix before feeding the modulator, e.g. an OFDM modulator. The precoder is fixed for a given band allocation. The transmitted vector consists of $K$ precoded data symbols

$$\bar{d} = Gd \qquad (1)$$

where $G$ is a $K \times K$ precoder matrix.

Using a projection precoder with rank $K - M$ where $M$ is a small constant, significant reduction of OOB emission can be achieved. The constructed precoder is an orthogonal projection, which by definition satisfies

    i) Hermitian, i.e. it is equal to its own conjugate-transpose: $G = G^H$,

    ii) idempotent, i.e. $G^2 = G$.

From these two properties it can be shown that an orthogonal projector with rank $K - M$ has the following eigenvalue decomposition

$$G = U \operatorname{diag} \left[ \underbrace{1, \ldots, 1}_{K-M}, \underbrace{0, \ldots, 0}_{M} \right] U^H, \qquad (2)$$

where $U$ is a unitary matrix that satisfies $UU^H = U^H U = I$, $I$ is the identity matrix, and diag[v] is the diagonal matrix with the values of $v$ on the diagonal.

After transmission and OFDM demodulation, the received vector is

$$r = Gd + n \qquad (3)$$

where n is assumed to be AWGN with covariance $N_0 I$, and the data vector $d$ is assumed to contain uncorrelated unit-energy symbols.

Using a projection matrix for spectral precoding has the drawback to inherently create a loss in the achievable data rate. From Shannon's law, the maximum achievable rate of the transmission equation (3) with uniform power allocation among the data (as it is typically done in practical wireless systems like LTE) is

$$I_{SP} = \log \det \left( I + \frac{1}{N_0} G \right) \qquad (4)$$

$$= \log \det U \left( I + \frac{1}{N_0} \operatorname{diag} \left[ \underbrace{1, \ldots, 1}_{K-M}, \underbrace{0, \ldots, 0}_{M} \right] \right) U^H \qquad (5)$$

$$= \log \det \operatorname{diag} \left[ \underbrace{1 + \frac{1}{N_0}, \ldots, 1 + \frac{1}{N_0}}_{K-M}, \underbrace{1, \ldots, 1}_{M} \right] \qquad (6)$$

$$\qquad (7)$$

$$= (K - M) \log(1 + \frac{1}{N_0})$$

where (5) comes from replacing $G$ by (2), and (6) follows by commuting the matrices in (5). If the transmission (3) is over $K$ frequency resources, as for OFDM and SC-FDMA with localized mapping, the spectral efficiency in [bps/Hz] is then

$$SE_{SP} = \frac{(K-M)}{K} \log(1 + \frac{1}{N_0}) \qquad (8)$$

Compared to the spectral efficiency of plain OFDM/SC-FDMA $C = \log(1 + \frac{1}{N_0})$, this corresponds to a theoretical rate loss of

$$R_{loss} = \frac{M}{K} \log(1 + \frac{1}{N_0}) \ . \qquad (9)$$

We remark that (8) is not the Shannon capacity of the system if non-uniform power allocation is considered. By water-filling among the data streams in (5), one could reallocate the transmission power of the $M$ streams with zero channel gain to the other $K - M$ streams. This would nevertheless not increase much the capacity in our regime of interest where $K$ is large and $M$ is small.

### Symbol estimation with iterative interference cancelation

The theoretical rate loss (9) is the result of interferences generated by $G$ among the data symbols. The interference cannot be always fully mitigated as the matrix $G$ is always non-invertible. Nevertheless, discreteness of the input can be exploited by a non-linear receiver to improve symbol estimation.

An iterative receiver has been proposed to improve the estimation of $d$ by mitigating this interference. The received vector (3) is treated as a noisy and distorted version of the transmitted vector:

$$r = d + \epsilon + n. \qquad (10)$$

where $\varepsilon$ is an in-band distortion of $d$. By identification, the distortion is equal to

$$\epsilon = \overline{d} - d$$
$$= (G - I)\, d \qquad (11)$$
$$= -G^{\perp} d$$

where $G^{\perp} = (I - G)$. It can be verified that $G^{\perp H} = G^{\perp}$ and $G^{\perp 2} = G^{\perp}$, and by definition $G^{\perp}$ is also an orthogonal projector. Because $(I - G) + G = I$, the projector $G^{\perp}$ projects onto the orthogonal complement of the image of $G$.

The receiver iteratively updates two steps. First, it cancels in the received vector $r$ the distortion $\varepsilon$ from previous symbol estimation. Then, it re-computes the symbol estimation accordingly.

Namely, at the $(j)$-th iteration, given the estimated data vector $\hat{d}^{(j-1)}$, the receiver produces the estimation variable $\hat{\varepsilon}^{(j)} = G^{\perp}(r - \hat{d}^{(j-1)})$. Here, post-multiplying by $G^{\perp}$ insures that $\hat{\varepsilon}^{(j)}$ always belongs to the same subspace as $\varepsilon$, and thus reduces the estimation error. Given the estimation of the distortion $\hat{\varepsilon}^{(j)}$, one gets the following signal reconstruction:

$$\overline{r}^{(j)} = r - \hat{\epsilon}^{(j)}$$
$$= r - (I - G)(r - \widehat{d}^{(j-1)}) \qquad (12)$$
$$= Gr + (I - G)\widehat{d}^{(j-1)}.$$

In the second step, the receiver performs the symbol estimation $\hat{d}^{(j)}$ based on the reconstructed signal $\overline{r}^{(j)}$ in (12). Since $K$, the size of the data vector, is typically large, for complexity reasons, estimation is done on per-index basis.

This means that the transmitted symbol $d_k$ on the $k$-th index of $\boldsymbol{d}$ is estimated given $\bar{r}_k^{(j)}$, the $k$-th component of $\bar{r}^{(j)}$.

Both hard-symbol and soft-symbol estimation have been considered. Hard-symbol estimation corresponds to finding the symbol in the constellation C that maximizes the likelihood probability, which is equivalent to

$$\hat{d}_k^{(j)} = \arg \min_{\alpha \in \mathcal{C}} \left\{ \left| \bar{r}_k^{(j)} - \alpha \right|^2 \right\}. \tag{13}$$

A soft-symbol estimation of $\hat{\boldsymbol{d}}^{(j)}$ is obtained by averaging over the constellation symbols weighted by their likelihood probabilities,

$$\hat{d}_k^{(j)} = \frac{\sum_{\alpha \in \mathcal{C}} \alpha \Pr\left(\bar{r}_k^{(j)} \mid d_k = \alpha\right)}{\sum_{\alpha \in \mathcal{C}} \Pr\left(\bar{r}_k^{(j)} \mid d_k = \alpha\right)} \tag{14}$$

where

$$\Pr\left(\bar{r}_i^{(j)} \mid d_i = \alpha\right) = \frac{1}{\pi N_0} e^{-\frac{\left| \bar{r}_i^{(j)} - \alpha \right|^2}{N_0}} \tag{15}$$

is the likelihood probability of $\bar{r}_i^{(j)}$ given the symbol $\alpha$.

**Design of spectral precoder**

Spectral precoding for two types of modulator shall be considered in the following: a classical OFDM modulator and a DFT-spread modulator called SC-FDMA.

*OFDM precoder construction*

The spectral precoder only depends on band allocation and can be constructed offline and loaded before transmission. The OFDM spectral precoder can be based on a M × K constrained matrix $\boldsymbol{A}$:

$$\boldsymbol{G}^{OFDM} = \boldsymbol{I} - \boldsymbol{A}^H (\boldsymbol{A}\boldsymbol{A}^H)^{-1} \boldsymbol{A}. \tag{16}$$

A direct verification shows that such construction satisfies the properties i) and ii) of an orthogonal projector. The parameter $M$ controls the level of out-of-band emission, the higher M, the less OOB emission.

Several methods have been devised to construct $\boldsymbol{A}$. One method consists on enforcing the $N$-continuity of the OFDM symbol, the constraint matrix corresponds to

$$\boldsymbol{A} = \begin{pmatrix} \boldsymbol{B}\boldsymbol{\Phi} \\ \boldsymbol{B} \end{pmatrix} \tag{17}$$

with

$$B = \begin{pmatrix} 1 & 1 & \dots & 1 \\ k_0 & k_1 & \dots & k_{K-1} \\ \vdots & \vdots & \ddots & \vdots \\ k_0^N & k_1^N & \cdots & k_{K-1}^N \end{pmatrix} \quad \text{and} \quad \Phi = diag \begin{pmatrix} e^{-j2\pi\frac{T_g}{T_s}k_0} \\ e^{-j2\pi\frac{T_g}{T_s}k_1} \\ \ddots \\ e^{-j2\pi\frac{T_g}{T_s}k_{K-1}} \end{pmatrix} \qquad (18)$$

where, $T_g$ is the length of a cyclic prefix of a multicarrier symbol; $T_s$ is a total length of the multicarrier symbol; $N$ is an integer; and $\{k_0, k_1, ..., k_{K-1}\}$ are the subcarrier indices, $K$ is the total number of subcarriers.

*Spectral precoder for SC-FDMA*

The spectral projection precoding method, originally devised for OFDM, can be adapted to SC-FDMA. The spectral precoder for SC-FDMA is obtained as

$$G^{SC-FDMA} = W^H G^{OFDM} W \qquad (19)$$

where $W$ is the DFT-precoder and $G^{OFDM}$ is the spectral precoder for OFDM.

While for OFDM systems most of the interference can be mitigated at the receiver, in spectrally-precoded SC-FDMA the average symbol error exhibits a high error floor. Moreover, the soft-symbol iterative receiver leads to error propagation, resulting in worse performance than hard-symbol iterative receiver.

**Transmit SIR**

The interference level introduced by spectral precoding operation can be described by the signal-to-interference ratio (SIR) of each data symbol after precoding. The SIR is defined as

$$\text{SIR} = \frac{\text{Desired signal power}}{\text{Interference power}} \qquad (20)$$

For the precoding operation (1), the SIR per-index can be expressed in terms of the diagonal elements of the precoder as

$$\text{SIR}_i = \frac{g_{i,i}}{1 - g_{i,i}} \qquad (21)$$

where the elements of the projection precoder are $G = \{g_{i,j}\}_{i,j=1}^{K}$.

To see this, let us write the per-index precoded data in (1) as

$$\bar{d}_i = g_{i,i} d_i + \sum_{k=1, k \neq i}^{K} g_{i,k} d_k. \qquad (22)$$

Assuming i.i.d. symbols with unit power, after averaging, the SIR reads

$$\text{SIR}_i = \frac{|g_{i,i}|^2}{\sum_{k=1, k \neq i}^{K} |g_{i,k}|^2}. \qquad (23)$$

As $G$ is an orthogonal projector, it is Hermitian and the diagonal elements are real and positive, i.e. $g_{i,i} \geq 0$. Moreover, by construction a projector is idempotent and it fulfills $GG^H = G^2 = G$. Accordingly, the diagonal element of $GG^H$, i.e. the square norm of the rows of $G$, are equal to the diagonal element of G, leading to

$$[\boldsymbol{GG^H}]_{i,i} = \sum_{k=1}^{K} |g_{i,k}|^2 = g_{i,i} \qquad (24)$$

Using (24) and further simple simplifications, the SIR expression reduces to (21), i.e. it only depends on the diagonal values of the projector. It follows that symbols index with smaller $g_{i,i}$ conveys symbols which are more difficult to detect at the receiver.

## Polarized Reception

Once we have determined the $\text{SIR}_i$ we can improve the average error rate performance by disregarding symbols detected at indices having low transmitted SIR. It means, given the precoder **G,** one directly identifies the set $\mathcal{I}_{N_r}$ of the $N_r$ indices with smallest diagonal elements, and then disregards symbols with indices in $\mathcal{I}_{N_r}$. These disregarded symbols are replaced by fixed, pre-determined symbols. They can be treated as punctured/erased transmitted symbols according to a predetermined puncturing pattern, which can be used in the receiver's decoder.

A simple choice for the value of pre-determined symbols is the average of the transmit constellation, e.g. zero for QAM. As such these symbols reflect complete uncertainty and do not impact the decoding decision.

*Flexible puncturing pattern*

Given a constellation of size $Q$, to the disregarded pattern of symbols $\mathcal{I}_{N_r}$ corresponds an equivalent puncturing pattern of bits where bits are grouped in packets of $\log_2 Q$. This may not be the best puncturing pattern of a FEC code.

For improved performance, one can permute the data at the transmitter so that an optimized puncturing pattern of a FEC scheme is used to match with the set $\mathcal{I}_{N_r}$ selected according to the spectral precoder.

Given a set of optimized punctured symbol indices $\wp_{N_r}$ with

$$|\wp_{N_r}| = |\mathcal{I}_{N_r}| = N_r,$$

one can define a permutation $\Pi$ on [1, ..., $K$] such that

$$\Pi: \wp_{N_r} \rightarrow \mathcal{I}_{N_r}.$$

To $\Pi$ and $\wp_{N_r}$ corresponds an equivalent permutation/interleaving operation and puncturing pattern on bits before constellation mapper, respectively. With a slight abuse of notation, we denote the equivalent bit-level operations as $\Pi$ and $\wp_{N_r}$. At the receiver side after demodulation and demapping, the received bits are de-interleaved by the corresponding inverse operation $\Pi^{-1}$. The bits corresponding to the positions $\wp_{N_r}$ are known dummy bits used for decoding purpose.

## Polarized Transmission

To further facilitate the symbol estimation at the receiver, we introduce a second polarizer at the transmitter. The transmit polarizer selects a set $\mathcal{I}_{N_t}$ of $N_t$ symbol indices according to the spectral precoder. Symbols with indices in $\mathcal{I}_{N_t}$ are replaced by dummy values which are a priori known by the receiver. This enables a better symbol estimation at the receiver by an improved iterative interference cancellation based on the knowledge of the values and indices $\mathcal{I}_{N_t}$ of the dummy symbols. A simple choice for the value of the dummy symbols is to select a fixed constellation symbol.

As with the receive polarizer, the set $\mathcal{I}_{N_t}$ is selected as the $N_t$ indices with smallest transmit SIR. As the SIR is only a function of the diagonal elements of the precoder, $\mathcal{I}_{N_t}$ can be fixed and known in advance by the receiver. The number of transmit dummy symbols must be less or equal to the number of punctured symbols in the receive polarizer, i.e. $0 \leq N_t \leq N_r$, so that

$$\mathcal{I}_{N_t} \subset \mathcal{I}_{N_r}.$$

**Polarized Spectrally-Precoded Transceiver**

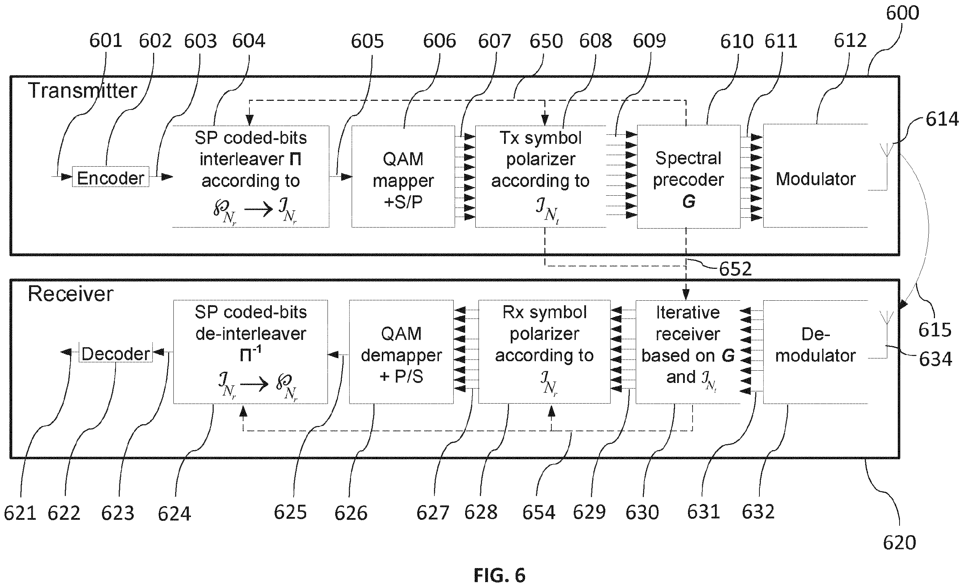

The overall method is illustrated in the block diagram of FIG. 6. Transmission is performed from a transmitter 600 to a receiver 620.

The transmitter 600 comprises an encoder 602, an interleaver 604, a QAM mapper and serial-to-parallel converter 606, a transmit symbol polarizer 608, which is a transformation unit, a spectral precoder 610, which is a precoder, a modulator 612, and an antenna unit 614. These units are arranged as a processing pipeline, i.e., the output of one of the units is provided as input to another unit in the pipeline.

The encoder 602 receives a set of initial symbols 601 and encodes these to obtain a set of encoded symbols 603. These are provided as input to the interleaver 604, which applies a mapping $\Pi: \wp_{N_r} \rightarrow$

$$\mathcal{I}_{N_r}.$$

The mapped set of symbols 605 is provided as input to a QAM mapper and serial-to-parallel converter 605. The QAM mapper and serial-to-parallel converter 606 performs a Quadrature amplitude modulation. In other embodiments, other modulation schemes may be applied. Furthermore, the QAM mapper and serial-to-parallel converter 606 performs a serial-to-parallel conversion to obtain a parallelized set of input symbols 607. This parallelized set of input symbols is provided as input to the transmit symbol polarizer 608.

The thus transformed set of input symbols 609 is provided as input to the spectral precoder 610. The precoded transformed set of input symbols 611 is then provided as input to the modulator 612 and transmitted using antenna 614 over a transmission path 615 to an antenna 634 of the receiver. The modulator 612 can be for example an OFDM modulator or a SC-FDMA modulator.

The polarizer 608 and the spectral precoder 610 jointly form a processing unit. This processing unit can be implemented as a separate physical unit or it can be part of a larger physical unit that also comprises further units of the transmission pipeline.

The receiver 620 comprises a receive antenna unit 634, a demodulator 632, an iterative receiver 630, which is an estimator, a receive symbol polarizer 628, a QAM demapper and parallel to serial converter 626, a de-interleaver 624, and a decoder 622.

The demodulator 632 demodulates the received signals from the antenna 634 to obtain a received set of symbols 631. The iterative receiver 630 estimates, based on knowledge of the precoding matrix G and of the subset used by the transmitter 600, an estimated set of symbols 629. The estimated set of symbols 629 is provided as input to the receive symbol polarizer 628 which transforms it into a set of symbols 627, which may be referred to as a "de-transformed" set of symbols 627. This is provided as input to the QAM demapper and parallel-to-serial converter 626. The QAM demapper and parallel-to-serial converter generates a serialized set of symbols 625 that is provided as input to the de-interleaver 624. The de-interleaver is configured to apply a mapping $\Pi^{-1}$ that is inverse to the mapping

$$\Pi: \wp_{N_r} \rightarrow \mathcal{I}_{N_r}$$

that is applied by the interleaver 604 of the transmitter 600. The de-interleaved symbols 623 that are generated by the de-interleaver 624 are provided as input to the decoder 622, which decodes them to obtain output symbols 621.

The receive symbol polarizer 628 and the iterative receiver 630 jointly form a processing unit of the receiver. This processing unit can be implemented as a separate physical unit or it can be part of a larger physical unit that also comprises further units of the receive pipeline.

Dashed arrows 650, 652, 654 show joint design sharing control data which can be done by hardware implementation or by control signaling. In particular, the de-interleaver 604 and/or the transmit symbol transformer 608 can be configured based on the precoding matrix of the spectral precoder 610, as indicated with dashed arrow 650. Furthermore, the iterative receiver 630 of the receiver 620 can be configured based on the precoding matrix of the spectral precoder 610 and/or based on the subset of the set of input symbols that is used by the transmit symbol transformer 608, as indicated with dashed arrow 652. Furthermore, the receiver symbol transformer 628 and the de-interleaver 624 can be configured based on the precoding matrix and information about the subset as stored at the iterative receiver 630.

The interleaver 604 can be configured to apply a mapping

$$\Pi: \wp_{N_r} \to \mathcal{J}_{N_r}$$

that maps the desired puncturing bit pattern $\wp_{N_r}$ to the indices $\mathcal{J}_{N_r}$ of symbols.

The iterative receiver 630 can be configured to fix the symbol estimation $\hat{d}_i^{(j)}$ to the known transmitted dummy value for all

$$i \in \mathcal{J}_{N_t}.$$

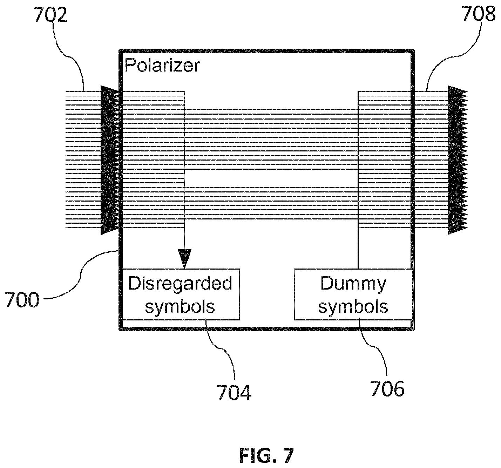

The concept of the polarizers (which is an example of a transformation unit) in FIG. 6 is illustrated in FIG. 7.

The polarizer 700 receives a set of input symbols 702. These input symbols are polarized into two groups. In a first group of specific symbol indices, input symbols are always disregarded, as indicated by reference number 704, and replaced by fixed values 706 (these can also be referred to as "dummy" symbols 706 since they are predetermined symbols that do not carry information). In the second group of indices, the symbols are untouched.

The polarized set of symbols 708 is provided as output of the polarizer 700.

In more detail, a receive polarizer can be configured to polarize received input symbol indices as

$$\mathcal{K}_{N_r} = [1, \dots, K] \backslash \mathcal{J}_{N_r}$$

where $\mathcal{J}_{N_r}$ is the set of disregarded indices in which symbols are replaced by fixed dummy values, known in advance for decoding purpose. The index set $\mathcal{J}_{N_r}$ is selected as the $N_r$ smallest diagonal values of the precoder **G.**

$\mathcal{K}_{N_r}$ is the set of decoded symbols carrying information.

The de-interleaver 624 can be configured to apply a mapping $\Pi^{-1}$ that is an inverse of the mapping $\Pi$ applied by the interleaver 604 of the transmitter. Thus, the de-interleaver can map back $\mathcal{J}_{N_r}$ to puncturing pattern $\wp_{N_r}$.

The transmit polarizer 608 can be configured to polarize the transmit symbol indices as

$$\mathcal{K}_{N_t} = [1, \dots, K] \backslash \mathcal{J}_{N_t}$$

where $\mathcal{J}_{N_t}$ is the set of symbols indices in which fixed dummy values are transmitted only for interference cancellation purpose. The indices are selected as the $N_t \leq N_r$ smallest diagonal values of the precoder G, so that

$$\mathcal{J}_{N_t} \subset \mathcal{J}_{N_r}.$$

$\mathcal{K}_{N_t}$ is the set of symbol indices carrying information.

**Performance evaluation and optimization**

The invention is particularly relevant for spectrally-precoded SC-FDMA transmission, as for spectrally precoded SC-FDMA, the errors are concentrated in few specific symbol indices. We consider a spectral precoder as given in Eq. (19) of the prior-art.

**SC-FDMA versus OFDM**

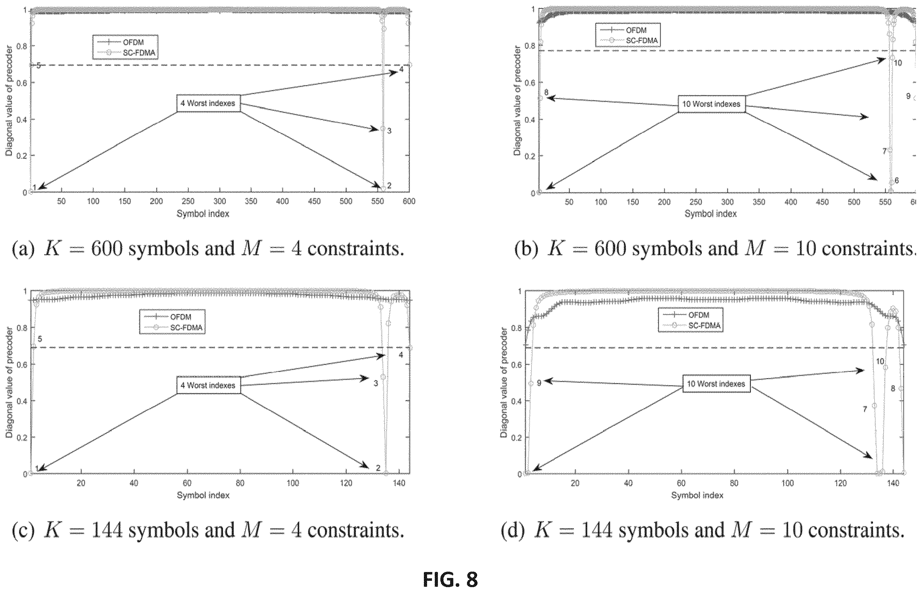

FIG. 8 shows diagonal values of projector precoders for SC-FDMA vs OFDM. In SC-FDMA, a small number of symbol experiences a very low transmit SIR. FIG.8 shows the diagonal values $\{g_{i,i}\}_{i=1}^{K}$ of spectral precoder for OFDM and SC-FDMA with $K$=144 and $K$=600, both with $M$=4 and $M$=10. One can see that the diagonal elements, which correspond to the per-symbol signal power, exhibit a much larger variance in SC-FDMA than in OFDM.

It can be observed that the number of indices where the signal power falls below 75-80% of the maximum is roughly equal to $M$.

While the total power of the precoder Tr[$G$] = $K$ - $M$ is more equally spread among the K indices with OFDM, spectrally-precoded SC-FDMA roughly concentrates the power in $K$ - $M$ indices, with M indices having low SNR values. This means that the spectral precoder is closer to a diagonal matrix, and thus closer to the capacity-achieving strategy in (4)-(7), with rate loss in (9).

These indices are around the values 0, $\frac{T_s - T_g}{T_s} K$, and $K$ for SC-FDMA with localized mapping.

This comes from the fact that the spectral precoder enforces continuity at the end and the beginning of the CP-OFDM time symbol which by circularity corresponds to time 0, ($T_s$ - $T_g$) and $T_s$ inside the OFDM symbol without CP. In FIG. 8 with LTE numerology, one can verify that the deeps are around the value 0, ≈ 0.93K, and K.

**The benefit of transmit polarization**

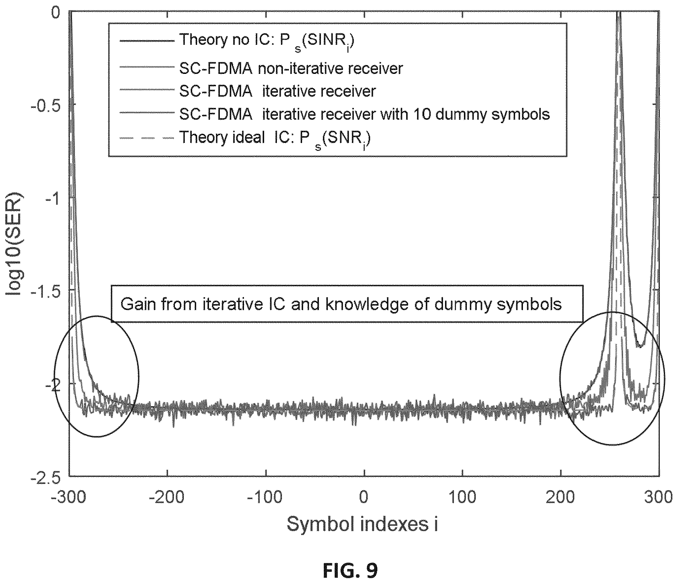

In FIG. 9, the average symbol error rate of SC-FDMA for ($K$=600, $M$=10) with 16QAM at 16dB SNR is shown for individual indices with and without soft-symbol iterative interference cancellation (IC). For the iterative receiver, two cases are considered: no a-priori knowledge of the transmitted values, and knowledge of 10 dummy values. This corresponds to set $N_t$ = 0 and $N_t$ = 10 in the transmit polarizer, respectively. It can be observed that knowledge of 10 dummy symbols improves detection of the neighboring symbols, this will enable to puncture less $N_r$ symbols in the receive polarizer, and thus increase the throughput.

The simulations are compared to the following analytical curves

- Using a Gaussian assumption of the interference (which is justified for large K by the central limit theorem), the performance of SER without IC, which at index $i$, is $P_s(\text{SINR}_i)$ where $\text{SINR}_i = \frac{g_{i,i}}{1 - g_{i,i} + N_0}$;

- The analytical bound of ideal IC which is $P_s(\text{SNR}_i)$ with $\text{SNR}_i = \frac{g_{i,i}}{N_0}$.

The symbol error probability $P_s(\gamma)$ for $Q$-QAM is given by

$$P_s(\gamma) = 2\left(1 - \frac{1}{\sqrt{Q}}\right)\text{erfc}\left(\sqrt{\frac{3\gamma}{2(Q-1)}}\right) - \left(1 - \frac{1}{\sqrt{Q}}\right)^2 \text{erfc}^2\left(\sqrt{\frac{3\gamma}{2(Q-1)}}\right) \tag{25}$$

where $Q$ is the constellation size.

It can be observed from FIG. 9 that for the non-dummy symbols estimated with the help of the few dummy symbols, the iterative IC receiver performs close to the optimum.

**Optimizing the parameters $N_r$ and $N_t$ in the polarizers**

While the average SER may be improved by increasing $N_r$ and $N_t$ this implies a data rate loss. The trade-off can be optimized in term of spectral efficiency. The optimal number of $N_r$ and $N_t$ symbols is mainly dependent of the number constraints in the precoder, but also depends on the number of subcarrier $K$, and the receiver-type. To evaluate this we consider the throughput (in bps/Hz) of uncoded symbols blocks.

The throughput is obtained via link simulation and is also compared to several analytical limiting throughput performances.

Firstly, without iterative IC receiver, the throughput in [bps/Hz] is

$$T^{\mathrm{NoIC}}(N_r) = \frac{\log_2(Q)\, T_s}{T_s + T_g} \frac{\mathcal{K}_{N_r}}{K} \left(1 - \mathrm{BLER}^{\mathrm{NoIC}}(N_r)\right) \tag{26}$$

where BLER$^{\mathrm{NoIC}}$ is the corresponding block error rate and

$$\mathcal{K}_{N_r} = [1, \dots, K] \setminus \mathcal{I}_{N_r}$$

are the only symbols used for information transmission. The received symbols have correlated interferences given in the last term of Eq. (22). The covariance between index $i$ and $j$ can be verified to be equal to $g_{i,j}(1 - g_{i,i} - g_{j,j})$. As shown in FIG. 8, most of the diagonal values $g_{i,i}$ are close to one and as a by-product most off-diagonal values are very small, cf Eq. (24). The covariance matrix is thus almost an identity matrix except for few indices, which are meanwhile sequentially disregarded by reducing the set $\mathcal{K}_{N_r}$. All together with the Gaussian behavior of the interference, one can approximate the joint block probability as the product of the marginal probabilities leading to

$$T^{\mathrm{NoIC}}(N_r) \approx \frac{\log_2(Q)\, T_s}{T_s + T_g} \frac{\mathcal{K}_{N_r}}{K} \prod_{i \in \mathcal{K}_{N_r}} \left(1 - P_s(\mathrm{SINR}_i)\right) \tag{27}$$

with $\mathrm{SINR}_i = \frac{g_{i,i}}{1 - g_{i,i} + N_0}$. This approximation is getting tighter as $N_r$ increases.

On the other hand, in the case of ideal per-index interference cancelation, symbol index would be independent, and one would have

$$T^{\mathrm{IdealIC}}(N_r) = \frac{\log_2(Q)\, T_s}{T_s + T_g} \frac{\mathcal{K}_{N_r}}{K} \prod_{i \in \mathcal{K}_N} \left(1 - P_s(\mathrm{SNR}_i)\right) \tag{28}$$

where $\mathrm{SNR}_i = \frac{g_{i,i}}{N_0}$.

Lastly, if no spectral precoding is applied, the reference performance is given by

$$T^{\mathrm{Ref}} = \frac{\log_2(Q)\, T_s}{T_s + T_g} \prod_{i \in K} \left(1 - P_s(1/N_0)\right) \tag{29}$$

which in high SNR regime $N_0 \to 0$ tends to $\frac{\log_2(Q) T_s}{T_s + T_g}$ which is the number of bits per constellation symbols and takes into account the cyclic prefix reduction. For example, with 16QAM and an LTE cyclic prefix ($\approx$ 7%), the reference throughput without spectral precoding is 3.74 bps/Hz.

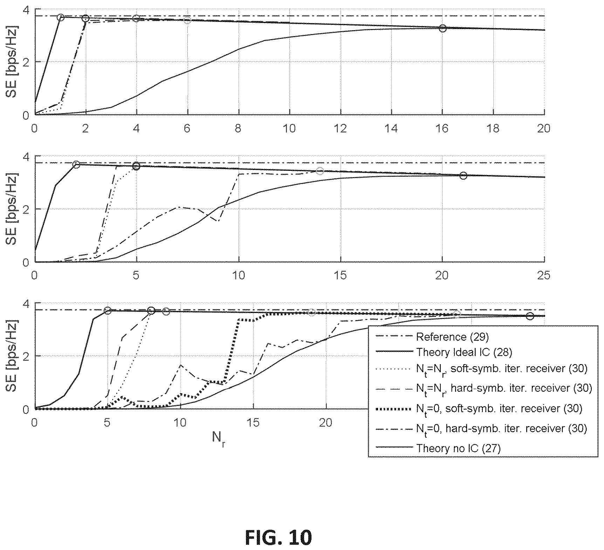

FIG. 10 shows the simulated throughput as function of $N_r$ at 25dB SNR for the two extreme cases $N_t = 0$ and $N_t = N_r$, each with hard-decision and soft-decision IC. The throughput is obtained as

$$T^{\text{Simu}}(N_r) = \frac{\log_2(Q)\,T_s}{T_s + T_g} \times \frac{\mathcal{K}_{N_r}}{K}(1 - \text{BLER}^{\text{simu}}) \qquad (30)$$

where BLER$^{\text{simu}}$ is the simulated block error rate. The analytical curves $T^{\text{NoIC}}(N_r)$, $T^{\text{IdealIC}}(N_r)$ and $T^{\text{Ref}}$ are also shown for comparison,. Three different numerologies with 16-QAM are considered: $K$=144 symbols with $M$=4, $K$=360 symbols with $M$=6, and $K$=600 symbols with $M$=10. The maximum of the curves are shown with circles on the figure and the corresponding value of $N_r$ are listed in Table 1.

It should be noted that without transmit polarization ($N_t = 0$), error propagation still occurs with soft-decision IC receiver and the throughput may be zero. The optimal value of $N_r$ symbol without transmit polarization ($N_t = 0$) is between M and 3M. With $N_t = N_r$, the optimal $N_r$ is less or equal to $M$, both for hard-decision and soft-decision IC receiver.

Table 1. Optimization of $N_r$ disregarded symbols in receive polarization with and without transmit polarization.

| $N_r$ | Theory ideal IC | $N_t = N_r$ soft-decision | $N_t = N_r$ hard-decision | $N_t = 0$ soft-decision | $N_t = 0$ hard-decision | Theory no IC |
|---|---|---|---|---|---|---|
| $K=144$, $M=4$ | 1 | 2 | 4 | NA | 6 | 16 |
| $K=360$, $M=6$ | 2 | 5 | 5 | NA | 14 | 21 |
| $K=600$, $M=10$ | 5 | 8 | 9 | 19 | 29 | 34 |

**Impact of the transmit polarizer to the transmit power spectrum**

In the transmit polarizer, some data symbols are replaced by dummy symbols before spectral precoder. The output signal of the spectral precoder thus always satisfied the desired constraints (e.g. N-continuity) enforced by projection. The impact of spectral precoding is not changed, and thus OOB emission is similar as in the conventional spectrally-precoded system. The design of the spectral precoder is thus independent of the transmit polarizer. Nevertheless, a different input signal may have a very different in-band spectrum at the output of the spectral precoder. This is nevertheless imperceptible as the number of dummy symbol can be kept small.

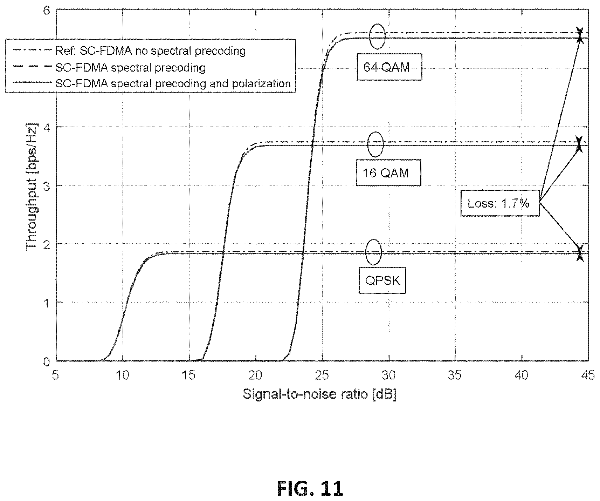

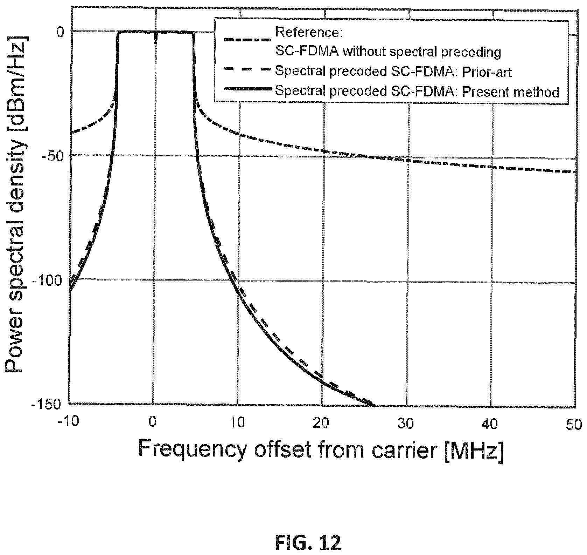

In FIG. 11, the benefit of the invention is illustrated for a 4-, 16- and 64-QAM SC-FDMA transmission with $K = 600$ symbols and a spectral precoder with M = 10 constraints. The receive and transmit polarizer are set with $N_t = N_r = 10$. The throughput of spectral-precoded SC-FDMA as in prior-art and spectral-precoded SC-FDMA with the method are obtained by simulations. As a reference, it is compared to the throughput of SC-FDMA without spectral precoder given in (29). One can see that with the present method, the throughput of spectrally-precoded SC-FDMA tightly follows the reference curve. On the contrary, the prior-art has zero spectral efficiency due to the error floor of the SER. The rate loss in high SNR corresponds here to the number of transmit dummy symbols: $\frac{N_t}{K}T^{\text{Ref}}$, i.e. a loss of $\approx$ 1.7% of reference throughput $T^{\text{Ref}}$. This rate loss is the small price to pay for the significant reduction of OOB emission shown in FIG. 12.

A similar polarization concept can be applied to spectrally precoded OFDM. For OFDM, spectrally precoded systems performance is close to optimal for QPSK and 16-QAM, and so polarization is not needed for these modulations. However, the performance of spectrally-precoded OFDM for 64 QAM presents a throughput loss. In this case, it can be mitigated by polarization. At 90% $T^{\text{Ref}}$, it gives a 1.5dB SNR from polarization compared to non-polarized spectrally-precoded system. The rate loss in high SNR compared to non-spectrally precoded system in this case is $\approx$ 2.1%.

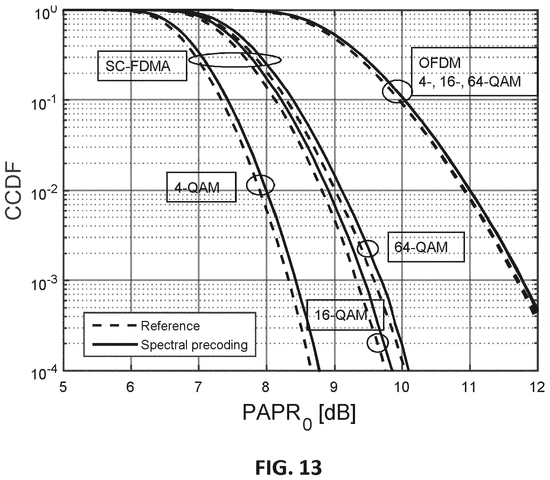

Finally, FIG. 13 shows the simulated Complementary-Cumulative-Distribution-Function (CCDF) of the Peak-to-Average-Power-Ratio (PAPR) with spectral precoded signals. Spectral precoding modifies the envelope of the signal and thus its PAPR. Simulations show that this effect is small, roughly 0.1dB degradation in PAPR. Therefore, spectrally-precoded SC-FDMA conserves its advantage in term of PAPR compared to OFDM.

Embodiments of the invention relate to:

- A polarization method of data symbols according the diagonal values of the projection precoder. The polarization consists of one group of symbols which is only used as supplementary information to the receiver to demodulate and decode the other group of symbols.

- A transmitter where polarization of the symbol is made such that one group of polarized symbol is replaced by dummy values before spectral precoding.

- A receiver where the value and positions of dummy symbols are used for interference cancellation in symbol estimation.

- A receiver where polarization of the symbols is made such that one group of polarized symbols is used only for decoding the other group of symbols.

- A polarization method where transmit and receive polarization are made on the same index set.

The foregoing descriptions are only implementation manners of the present invention, the scope of the present invention is not limited to this. Any variations or replacements can be easily made through person skilled in the art. Therefore, the protection scope of the present invention should be subject to the protection scope of the attached claims.

**Claims**

1. A processing unit (100; 608, 610) for a transmitter, the processing unit comprising:

   - a transformation unit (110; 608) configured to replace a subset of a set of input symbols (702) with one or more fixed symbols to obtain a transformed set of symbols (708), and
   - a precoder (120; 610) configured to apply a precoding matrix to the transformed set of symbols to obtain a precoded transformed set of symbols,

   wherein the subset is based on a distortion of the precoding matrix.

2. The processing unit (100; 608, 610) according to claim 1, wherein the precoding matrix is an orthogonal projection matrix, and one or more indices of the subset of the set of input symbols (702) correspond to one or more indices of smallest diagonal values of the precoding matrix.

3. The processing unit (100; 608, 610) according to one of the previous claims, wherein the subset of the set of input symbols comprises $N_t$ elements with $M/2 \leq N_t \leq 3M$, wherein $M$ is a rank of a null space of the precoding matrix.

4. The processing unit (100; 608, 610) according to one of the previous claims, further comprising an interleaver (604) configured to map from a predefined puncturing bit pattern to a set of indices of the subset of the set of input symbols.

5. The processing unit (100; 608, 610) according to one of the previous claims, further comprising an OFDM modulator or a SC-FDMA modulator (612) configured to modulate the transformed set of symbols.

6. A system (300) for transformed transmission, the system comprising:

   - a transmitter (310) comprising a transmitter processing unit (100; 608, 610) according to one of the claims 1 to 5, and
   - a receiver (320) comprising a receiver processing unit (200; 628, 630), which comprises:

     an estimator (210; 630) configured to estimate a set of received symbols based on a precoding matrix to obtain an estimated set of symbols, and
     a transformation unit (220; 628) configured to replace a subset of the estimated set of symbols with one or more fixed receive symbols to obtain a transformed estimated set of symbols,

   wherein the subset of the set of input symbols of the transmitter processing unit is a subset of the subset of the estimated set of symbols of the receiver processing unit.

7. The system of claim 6, wherein the processing unit (200; 628, 630) further comprises a de-interleaver (624) configured to map from a set of indices of the subset of the set of input symbols to a predefined puncturing bit pattern.

8. The system (300) of claim 6 or 7, wherein the subset of the set of input symbols of the transmitter processing unit (100; 608, 610) and the subset of the estimated set of symbols of the receiver processing (200; 628, 630) unit have the same elements.

9. The system (300) of any of claim 6 to 8, wherein the estimator (630) of the receiver processing unit is configured to estimate the set of received symbols based on the precoding matrix of the transmitter processing unit and based on the subset of the set of input symbols of the transmitter processing unit.

10. The system (300) of one of claims 6 to 9, wherein the interleaver (604) of the transmitter processing unit (100; 608, 610) is configured to perform a mapping that is inverse to the mapping of the de-interleaver of the receiver processing unit.

11. A method (400) for transformed transmission, the method comprising:

- replacing (410) a subset of a set of input symbols with one or more fixed transmit symbols (706) to obtain a transformed set of symbols (708), and
- applying (420) a precoding matrix to the transformed set of symbols (708) to obtain a precoded transformed set of symbols,

wherein the subset is based on a distortion of the precoding matrix.

12. The method (400) of claim 11, further comprising a step of transmitting to a receiver processing unit an information about the precoding matrix, the subset of the set of input symbols and/or a subset of the estimated set of symbols.

13. A computer-readable storage medium storing program code, the program code comprising instructions for carrying out the method of one of claims 11 or 12.

**Patentansprüche**

1. Verarbeitungseinheit (100; 608, 610) für einen Sender, wobei die Verarbeitungseinheit Folgendes umfasst:

- eine Transformationseinheit (110; 608), die konfiguriert ist, um einen Teilsatz eines Satzes von Eingabesymbolen (702) durch ein oder mehrere feste Symbole zu ersetzen, um einen transformierten Satz von Symbolen (708) zu erhalten, und
- einen Vorcodierer (120; 610), der konfiguriert ist, um eine Vorcodierungsmatrix auf den transformierten Satz von Symbolen anzuwenden, um einen vorcodierten transformierten Satz von Symbolen zu erhalten,

wobei der Teilsatz auf einer Verzerrung der Vorcodierungsmatrix basiert.

2. Verarbeitungseinheit (100; 608, 610) nach Anspruch 1, wobei die Vorcodierungsmatrix eine Orthogonalprojektionsmatrix ist und ein oder mehrere Indizes des Teilsatzes des Satzes von Eingabesymbolen (702) einem oder mehreren Indizes der kleinsten Diagonalwerte der Vorcodierungsmatrix entsprechen.

3. Verarbeitungseinheit (100; 608, 610) nach einem der vorhergehenden Ansprüche, wobei der Teilsatz des Satzes von Eingabesymbolen $N_t$ Elemente mit $M/2 \leq N_t \leq 3M$ umfasst, wobei $M$ ein Rang eines Nullraums der Vorcodierungsmatrix ist.

4. Verarbeitungseinheit (100; 608, 610) nach einem der vorhergehenden Ansprüche, ferner umfassend einen Verschachteler (604), der konfiguriert ist, um von einem vordefinierten Punktierbitmuster auf einen Satz von Indizes des Teilsatzes des Satzes von Eingabesymbolen zuzuordnen.

5. Verarbeitungseinheit (100; 608, 610) nach einem der vorhergehenden Ansprüche, ferner umfassend einen OFDM-Modulator oder einen SC-FDMA-Modulator (612), der konfiguriert ist, um den transformierten Satz von Symbolen zu modulieren.

**6.** System (300) für eine transformierte Sendung, wobei das System Folgendes umfasst:

- einen Sender (310), der eine Senderverarbeitungseinheit (100; 608, 610) nach einem der Ansprüche 1 bis 5 umfasst, und
- einen Empfänger (320), der eine Empfängerverarbeitungseinheit (200; 628, 630) umfasst, die Folgendes umfasst:

einen Schätzer (210; 630), der konfiguriert ist, um einen Satz von empfangenen Symbolen basierend auf einer Vorcodierungsmatrix zu schätzen, um einen geschätzten Satz von Symbolen zu erhalten, und eine Transformationseinheit (220; 628), die konfiguriert ist, um einen Teilsatz des geschätzten Satzes von Symbolen durch ein oder mehrere feste Empfangssymbole zu ersetzen, um einen transformierten geschätzten Satz von Symbolen zu erhalten, wobei der Teilsatz des Satzes von Eingabesymbolen der Senderverarbeitungseinheit ein Teilsatz des Teilsatzes des geschätzten Satzes von Symbolen der Empfängerverarbeitungseinheit ist.

**7.** System nach Anspruch 6, wobei die Verarbeitungseinheit (200; 628, 630) ferner einen Entschachteler (624) umfasst, der konfiguriert ist, um von einem Satz von Indizes des Teilsatzes des Satzes von Eingabesymbolen auf ein vordefiniertes Punktierbitmuster zuzuordnen.

**8.** System (300) nach Anspruch 6 oder 7, wobei der Teilsatz des Satzes von Eingabesymbolen der Senderverarbeitungseinheit (100; 608, 610) und der Teilsatz des geschätzten Satzes von Symbolen der Empfängerverarbeitungseinheit (200; 628, 630) die gleichen Elemente aufweisen.

**9.** System (300) nach einem der Ansprüche 6 bis 8, wobei der Schätzer (630) der Empfängerverarbeitungseinheit konfiguriert ist, um den Satz von empfangenen Symbole basierend auf der Vorcodierungsmatrix der Senderverarbeitungseinheit und basierend auf dem Teilsatz des Satzes von Eingabesymbolen der Senderverarbeitungseinheit zu schätzen.

**10.** System (300) nach einem der Ansprüche 6 bis 9, wobei der Verschachteler (604) der Senderverarbeitungseinheit (100; 608, 610) konfiguriert ist, um eine Zuordnung, die umgekehrt zu der Zuordnung des Verschachtelers der Empfängerverarbeitungseinheit ist, durchzuführen.

**11.** Verfahren (400) für transformierte Sendung, wobei das Verfahren Folgendes umfasst:

- Ersetzen (410) eines Teilsatzes eines Satzes von Eingabesymbolen durch ein oder mehrere feste Sendesymbole (706), um einen transformierten Satz von Symbolen (708) zu erhalten, und
- Anwenden (420) einer Vorcodierungsmatrix auf den transformierten Satz von Symbolen (708), um einen vorcodierten transformierten Satz von Symbolen zu erhalten, wobei der Teilsatz auf einer Verzerrung der Vorcodierungsmatrix basiert.

**12.** Verfahren (400) nach Anspruch 11, ferner umfassend einen Schritt des Sendens einer Information über die Vorcodierungsmatrix, den Teilsatz des Satzes von Eingabesymbolen und/oder einen Teilsatz des geschätzten Satzes von Symbolen an eine Empfängerverarbeitungseinheit.

**13.** Computerlesbares Speichermedium, das einen Programmcode speichert, wobei der Programmcode Anweisungen zum Ausführen des Verfahrens nach einem der Ansprüche 11 oder 12 umfasst.

**Revendications**

**1.** Unité de traitement (100 ; 608, 610) pour un émetteur, l'unité de traitement comprenant :

- une unité de transformation (110 ; 608) configurée pour remplacer un sous-ensemble d'un ensemble de symboles d'entrée (702) par un ou plusieurs symboles fixes pour obtenir un ensemble de symboles transformé (708), et
- un précodeur (120 ; 610) configuré pour appliquer une matrice de précodage à l'ensemble de symboles transformé pour obtenir un ensemble de symboles transformé précodé,

le sous-ensemble étant basé sur une distorsion de la matrice de précodage.

2. Unité de traitement (100 ; 608, 610) selon la revendication 1, dans laquelle la matrice de précodage est une matrice de projection orthogonale, et un ou plusieurs indices du sous-ensemble de l'ensemble de symboles d'entrée (702) correspondent à un ou plusieurs indices des plus petites valeurs diagonales de la matrice de précodage.

3. Unité de traitement (100 ; 608, 610) selon l'une quelconque des revendications précédentes, dans laquelle le sous-ensemble de l'ensemble de symboles d'entrée comprend $N_t$ éléments où $M/2 \leq N_t \leq 3M$, $M$ étant un rang d'un espace nul de la matrice de précodage.

4. Unité de traitement (100 ; 608, 610) selon l'une quelconque des revendications précédentes, comprenant en outre un entrelaceur (604) configuré pour effectuer un mappage à partir d'un motif de bits de poinçonnage prédéfini sur un ensemble d'indices du sous-ensemble de l'ensemble de symboles d'entrée.

5. Unité de traitement (100 ; 608, 610) selon l'une quelconque des revendications précédentes, comprenant en outre un modulateur OFDM ou un modulateur SC-FDMA (612) configuré pour moduler l'ensemble de symboles transformé.

6. Système (300) de transmission transformée, le système comprenant :

   - un émetteur (310) comprenant une unité de traitement d'émetteur (100 ; 608, 610) selon l'une quelconque des revendications 1 à 5, et
   - un récepteur (320) comprenant une unité de traitement de récepteur (200 ; 628, 630), qui comprend :

      un estimateur (210 ; 630) configuré pour estimer un ensemble de symboles reçus sur la base d'une matrice de précodage pour obtenir un ensemble estimé de symboles, et
      une unité de transformation (220 ; 628) configurée pour remplacer un sous-ensemble de l'ensemble estimé de symboles par un ou plusieurs symboles de réception fixes pour obtenir un ensemble de symboles estimé transformé,

   le sous-ensemble de l'ensemble de symboles d'entrée de l'unité de traitement d'émetteur étant un sous-ensemble du sous-ensemble de l'ensemble estimé de symboles de l'unité de traitement de récepteur.

7. Système selon la revendication 6, dans lequel l'unité de traitement (200 ; 628, 630) comprend en outre un désentrelaceur (624) configuré pour effectuer un mappage d'un ensemble d'indices du sous-ensemble de l'ensemble de symboles d'entrée à un motif de bits de poinçonnage prédéfini.

8. Système (300) selon la revendication 6 ou 7, dans lequel le sous-ensemble de l'ensemble de symboles d'entrée de l'unité de traitement d'émetteur (100 ; 608, 610) et le sous-ensemble de l'ensemble estimé de symboles de l'unité de traitement de récepteur (200 ; 628, 630) ont les mêmes éléments.

9. Système (300) selon l'une quelconque des revendications 6 à 8, dans lequel l'estimateur (630) de l'unité de traitement de récepteur est configuré pour estimer l'ensemble de symboles reçus sur la base de la matrice de précodage de l'unité de traitement d'émetteur et sur la base du sous-ensemble de l'ensemble de symboles d'entrée de l'unité de traitement d'émetteur.

10. Système (300) selon l'une des revendications 6 à 9, dans lequel l'entrelaceur (604) de l'unité de traitement d'émetteur (100 ; 608, 610) est configuré pour effectuer un mappage qui est inverse au mappage du désentrelaceur de l'unité de traitement de récepteur.

11. Procédé (400) de transmission transformée, le procédé comprenant :

   - le remplacement (410) d'un sous-ensemble d'un ensemble de symboles d'entrée par un ou plusieurs symboles d'émission fixes (706) pour obtenir un ensemble de symboles transformé (708), et
   - l'application (420) d'une matrice de précodage à l'ensemble de symboles transformé (708) pour obtenir un ensemble de symboles transformé précodé,

   le sous-ensemble étant basé sur une distorsion de la matrice de précodage.

**12.** Procédé (400) selon la revendication 11, comprenant en outre une étape consistant à transmettre à une unité de traitement de récepteur une information sur la matrice de précodage, le sous-ensemble de l'ensemble de symboles d'entrée et/ou un sous-ensemble de l'ensemble de symboles estimé.

**13.** Support de stockage lisible par ordinateur stockant un code de programme, le code de programme comprenant des instructions pour exécuter le procédé selon l'une quelconque des revendications 11 ou 12.

110                120

| transformation unit | → | precoder |

100

**FIG. 1**

220                210

| transformation unit | ← | estimator |

200

**FIG. 2**

100

310

200

320

**FIG. 3**

Replacing a subset of a set of input symbols with one or more fixed transmit symbols — 410

Applying a precoding matrix to the transformed set of symbols — 420

400

**FIG. 4**

Estimating a set of received symbols

510

Replacing a subset of the estimated set of symbols with one or more fixed receive symbols

520

500

**FIG. 5**

**FIG. 6**

EP 3 427 397 B1

**FIG. 7**

EP 3 427 397 B1

(a) $K = 600$ symbols and $M = 4$ constraints.

(b) $K = 600$ symbols and $M = 10$ constraints.

(c) $K = 144$ symbols and $M = 4$ constraints.

(d) $K = 144$ symbols and $M = 10$ constraints.

FIG. 8

**FIG. 9**

FIG. 10

**FIG. 11**

**FIG. 12**

**FIG. 13**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014362934 A1
- WO 9624989 A2
- US 2010254494 A1
- WO 2011009239 A1